Europäisches Patentamt

(19) European Patent Office

Office européen des brevets

(11) EP 0 755 115 A1

## (12) EUROPEAN PATENT APPLICATION

(43) Date of publication:
22.01.1997 Bulletin 1997/04

(51) Int. Cl.⁶: H03H 11/04

(21) Application number: 96111171.3

(22) Date of filing: 11.07.1996

(84) Designated Contracting States:
DE FR GB

(30) Priority: 20.07.1995 JP 206433/95

(71) Applicant: MOTOROLA, INC.
Schaumburg, IL 60196 (US)

(72) Inventors:
• Takahashi, Jun
Sendi-shi, Miyagi 898-31 (JP)

• Kamata, Takatsugu
Sendai-shi, Miyagi 981-31 (JP)
• Ogasawara, Hiroshi
Sendai-shi Miyagi 989-32 (JP)

(74) Representative: Hudson, Peter David et al
Motorola
European Intellectual Property
Midpoint
Alencon Link
Basingstoke, Hampshire RG21 7PL (GB)

### (54) Active low pass filter

(57) A compact, lightweight active low-pass filter (LPF) is provided which can minimize output noise and attain a high Q. The active LPF comprises: a transconductance amplifier 1 for inputting a frequency signal and amplifying a differential voltage between a feedback voltage at an output terminal of the LPF and an input voltage to output it as a current; an emitter follower 2 connected via a resistor R3 to an output end of the transconductance amplifier 1; an emitter follower 3 connected via a resistor R to an output end of the emitter follower 1; capacitors C0 and C1 provided at the output end of the transconductance amplifier 1 and the input end of the emitter follower 3, respectively; a capacitor C2 disposed between the output end of the emitter follower 3 and the input end of the emitter follower 2; and resistors R1 and R2 for dividing the output voltage of the LPF to feed it back to the transconductance amplifier 1.

FIG. 1

EP 0 755 115 A1

## Description

TECHNICAL FIELD

The present invention relates to an active low-pass filter.

BACKGROUND

In a digital cordless telephone, for example, a quadrature-type FM demodulation circuit is required, where a phase shifter circuit with a 90-degree input is used. This 90-degree phase shifter circuit generates a signal 90 degrees out of phase with respect to an input signal having a center frequency of f0 as shown in Fig. 7; in this case, it is desirable that the its Q value (quality factor indicative of how sharp the peak shape of the center frequency f0 is) is as great as possible.

Prior art examples of phase shifter circuit of this type are shown in Figs. 8-10. The circuit in Fig. 8 is a passive high-pass filter that is formed by combining a resistor R, a coil L, a capacitor C0 and a varicap diode CV, where the adjustment of the center frequency f0 is made by changing the terminal voltage of the varicap diode CV to vary its capacitance value.

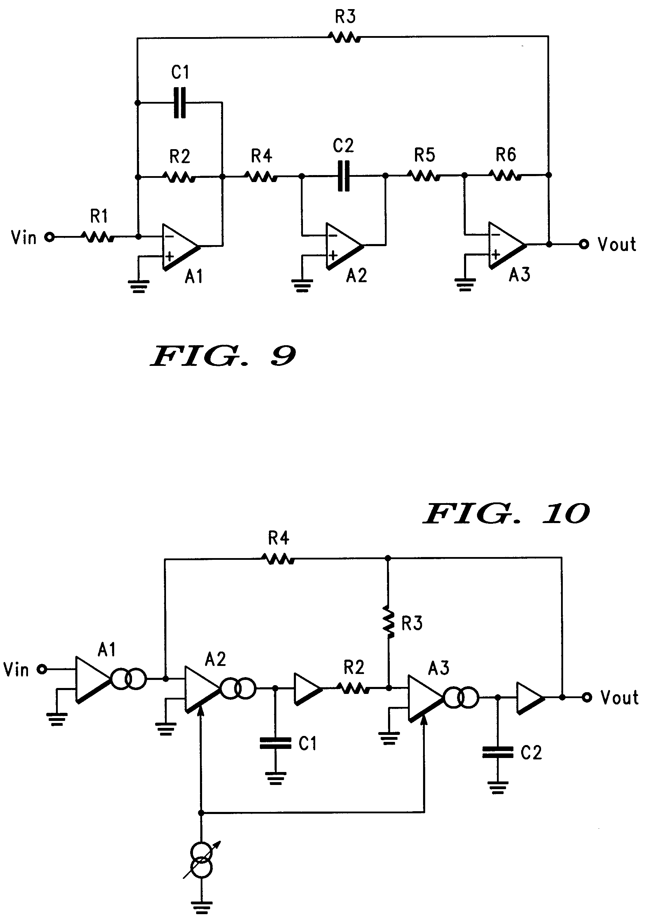

The circuit shown in Fig. 9 is a typical bi-quad low-pass filter formed by combining operational amplifiers A1-A3, resistors R1-R6 and capacitors C1 and C2.

The circuit depicted in Fig. 10 is an active low-pass filter that has already been filed by the inventor of the present invention, where it is comprised of three voltage-current amplifiers (transconductance amplifiers) A1-A3, resistors R1-R3, capacitors C1 and C2, and a current controller adj. This low-pass filter (LPF) is a second-order filter (as may become apparent later by solving the transfer function), such that its cut-off frequency f0 is adjusted by varying the amplification factors of the amplifiers A2 and A3 with the current controller adj. Exactly speaking, the center frequency and cut-off frequency have different meanings: however, in order to avoid complexity of symbols used, both are hereinbelow denoted by f0. It should also be noted that although the same symbols are used in the drawings, the same symbols used in different drawings do not necessarily have the same characteristics.

The passive high-pass filter illustrated in Fig. 8 is easier to adjust than those designed to adjust the center frequency f0 by changing the coil L; however, it requires adjusting the terminal voltage of the varicap diode, and it is difficult to reduce its size and weight because it is comprised of external parts. Even if variations in DC voltage of the FM demodulation output are used to control the terminal voltage of the varicap diode, thereby eliminating the need for adjustment, its external circuitry become complicated to increase the size of the filter itself; in addition, as the temperature dependency of its external parts are exhibited, f0 and Q become increasingly dependent upon temperature.

For the active LPF shown in Fig. 9, there are many external parts, which requires larger real estate and results in higher cost. As such, the filters shown in Fig. 8 and 9, although used in portable products such as cordless telephone units, are not suited to implement reduction in size and weight and eliminate the need for adjustment.

On the other hand, with the bi-quad LPF depicted in Fig. 10, because the amplification factors of the amplifiers A2 and A3 are changed by the current controller adj to adjust its cut-off frequency f0, it is superior to the afore-described circuits in that fewer external parts are required and that a reduction in size and elimination of adjustment can be implemented.

The present invention is intended to further improve the active LPF shown in Fig. 10, and its purpose is to provide an active low-pass filter which allows for reduction in size and weight and can minimize its output noise.

SUMMARY OF THE INVENTION

The invention according to Claim 1 comprises an amplifier for acquiring a frequency signal into one input terminal and amplifying a differential voltage between one and other input terminals to output it as a current; a first capacitive element provided between the output terminal of the amplifier and a first potential source; a first impedance converter having its input terminal connected via a first resistor to the output terminal of said amplifier; a second impedance converter having its input terminal connected via a second resistor to the output terminal of said first impedance converter and having its output terminal connected to the other input terminal of said amplifier; a second capacitive element connected between said second resistor and the input terminal of said second impedance converter and the first potential source; and a third capacitive element having one terminal connected between said first resistor and the input terminal of said first impedance converter, and having the other terminal connected to the output terminal of said second impedance converter.

The invention according to Claim 2 further comprises a third resistor connected between the other input terminal of said amplifier and a second potential source; and a fourth resistor having one terminal connected between the other input terminal of said amplifier and said third resistor, and having the other terminal connected to the output terminal of said second impedance converter.

BRIEF DESCRIPTION OF THE DRAWINGS

Fig. 1 is a circuit diagram illustrating one example of how the present invention is implemented.

Fig. 2 is a circuit diagram illustrating one embodiment of the present invention.

Fig. 3 is a characteristics chart illustrating frequency and phase characteristics determined by simulation based on the active LPF of the present invention.

Fig. 4 is a characteristics chart illustrating frequency and phase characteristics determined by simulation based on the active LPF of the present invention.

Fig. 5 is a characteristics chart illustrating frequency and phase characteristics determined by simulation based on the active LPF of the present invention.

Fig. 6 is a characteristics chart illustrating frequency and phase characteristics determined by simulation based on the active LPF of the present invention.

Fig. 7 is a characteristics chart illustrating frequency and phase characteristics of an LPF.

Fig. 8 is a circuit diagram illustrating a prior art passive band-pass filter.

Fig. 9 is a circuit diagram illustrating a prior art active LPF.

Fig. 10 is a circuit diagram illustrating a comparative example of the active LPF.

DETAILED DESCRIPTION OF THE PREFERRED EMBODIMENT

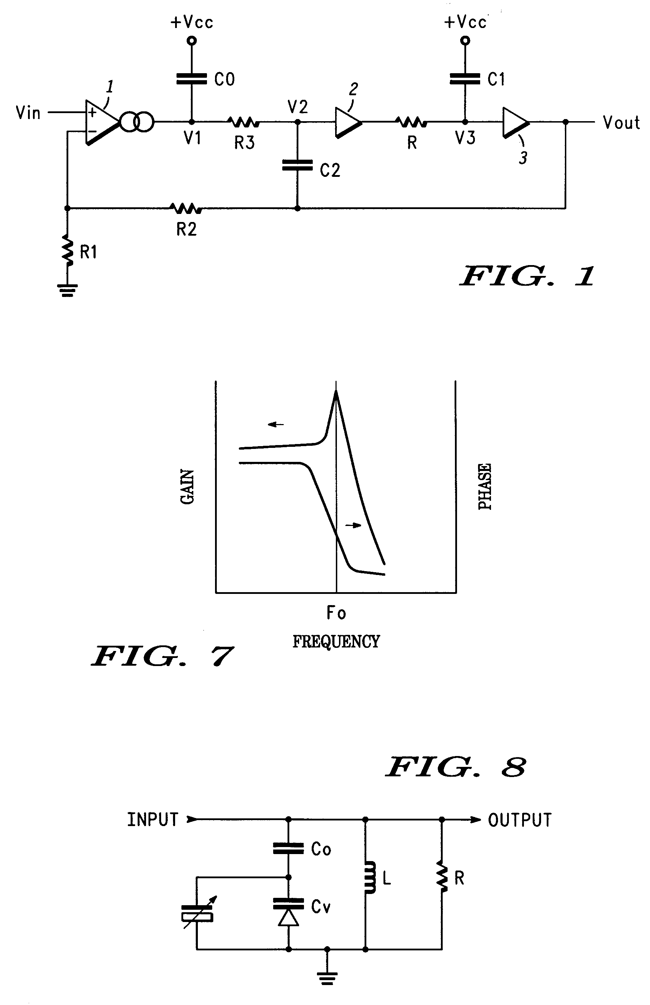

Fig. 1 is a circuit diagram illustrating one example of how the present invention is implemented. In Fig. 1, reference numeral 1 denotes an amplifier (transconductance amplifier) for acquiring a frequency signal into its positive input terminal and amplifying the input voltage to output it as a current.

To an output terminal of the transconductance amplifier 1 is connected one terminal of a capacitor C0, which comprises a first capacitive element, the other terminal of which is connected to a first potential source, e.g., a high potential source VCC. This high potential source VCC is at a +VCC potential. One terminal of the capacitor C0 is connected via a resistor R3, which comprises a first resistor element, to an input terminal of an emitter follower 2, which comprises a first impedance converter. To the output terminal of the emitter follower 2 is connected via a resistor R, which comprises a second resistor element, one terminal of a capacitor C1, which comprises a second capacitive element, while the other terminal of the capacitor C1 is connected to the high potential source VCC.

One terminal of the capacitor C1 (a node between the capacitor C1 and resistor R) is connected to an input terminal of an emitter follower 3, which comprises a second impedance converter. The output terminal of the emitter follower 3 corresponds to an output terminal of the active LPF according to the present invention, such that this output terminal is connected via a resistor R2, which comprises a forth resistor element, to a negative input terminal of the transconductance amplifier 1. To a node between the negative input terminal of the transconductance amplifier 1 and the resistor R2 is connected one terminal of a resistor R1, which comprises a third resistor element, while the other terminal of the resistor R1 is AC grounded to earth, which is at a low potential. It should be noted that earth or ground, in this example, corresponds to a second potential source. Furthermore, the output terminal of the second emitter follower 3 is connected to the input terminal of the first emitter follower 2 via C2, which comprises a third capacitive element.

So configured, the active LPF operates as follows. When a frequency signal is applied to the positive input terminal of the transconductance amplifier 1, the transconductance amplifier 1 amplifies a difference between the voltage of input signal Vin and a feedback voltage that is fed back from the output of the active LPF and divided by the resistors R1 and R2, and outputs it as a current. A voltage V1 is developed at one terminal of the capacitor C0 according to this current. The voltage V1 is then converted by the resistor R3 and capacitor C2 to a voltage V2, which is, in turn, outputted from the emitter follower 2. The output voltage V2 of the emitter follower 2 is converted by the resistor R and capacitor C1 to a voltage V3, which is then extracted as an output voltage Vout of the active LPF, and also fed back via the resistor R2 and capacitor C2 to the respective inputs of the transconductance amplifier 1 and first emitter follower 2.

Now, the above active LPF is described as a low-pass filter that comprises a 90 degree phase shifter circuit. First, the transfer function of this circuit is determined. It should be noted here that various symbols, such as Vin, C0, and R3, for the portions shown in Fig. 1 not only represent the corresponding symbols for such portions for the sake of convenience, but also denote their corresponding voltage value, capacitance, and resistance value, respectively, so equations described below are written using those symbols. Also note that the third capacitor C2 has its capacitance set at $K \cdot C0$. In each equation, S denotes a complex variable ($S = jw$, where w is a frequency); and gm denotes DI/DV (where DI denotes variations in collector current of a transistor that forms an amplifier, while DV denotes variations in base-to-emitter voltage).

By determining the relations for Vin, Vout, V1 and V2, the following equations (1) through (3) hold true.

[Equation 1]

$$(Vin - Vout * \frac{R1}{R1+R2})*gm = SC0V1+(\frac{V1-V2}{R3}) \tag{1}$$

$$Vout = \frac{1}{1+SC1R}*V2 \tag{2}$$

$$\frac{V1-V2}{R3} = (V2-Vout)SKC0 \tag{3}$$

From the above Eqs. (1)-(3), the following equation (4) holds true, so that the transfer function may be expressed as Eq. (5).

[Equation 2]

$$(Vin - Vout * \frac{R1}{R1+R2})*gm = SC0V1+(V2-V0)SKC0 \tag{4}$$

$$= S*C0\{(V2-Vout)SKC0R3+V2\}+(V2-Vout)SKC0$$

$$= S^2KC0^2R3(V2-Vout)+SC0V2+SKC0(V2-Vout)$$

$$= S^2KC0^2R3\{(1+SC1R)Vout - Vout\} +SC0(1+SC1R)Vout+SKC0\{(1+SC1R)Vout - Vout\}$$

$$= S^3KC0^2C1RR3Vout+S^2(K+1)C0C1RVout+SC0Vout$$

$$\frac{Vout}{Vin} = \frac{gm}{S^3KC0^2C1RR3+S^2(K+1)C0C1R+SC0+\frac{R1*gm}{R1+R2}} \tag{5}$$

$$= \frac{\frac{gm}{(K+1)C0C1R}}{\frac{K}{1+K}*C0R3S^3+S^2+\frac{1}{(1+K)C1R}*S+\frac{gm}{(1+K)C0C1R}(\frac{R1}{R1+R2})}$$

Now assuming that the angular frequency in the cut-off frequency f0 is represented by w0, then w0 may be written as Eq. (6) in consideration of the above Eq. (5).

[Equation 3]

$$Wo = \frac{1}{\sqrt{(1+K)C0C1R(\frac{1}{gm}) (\frac{R1+R2}{R1})}} \tag{6}$$

Also, given the above Eq. (5), Q (quality factor) may be expressed as Eq. (7) with w = w0 , where Q* is a value of Q with R3 = 0, and written as Eq. (8).

[Equation 4]

$$Q = \frac{Wo^2}{-AWo^3+\frac{Wo^2}{Q^*}} = \frac{1}{\frac{1}{Q^*}*(1-A*Q*Wo)} = \frac{Q^*}{1-AQWo} \tag{7}$$

$$Q^* = \frac{(1+K)C1R}{\sqrt{C0 (\frac{1}{gm}) (\frac{R1+R2}{R1})}} \tag{8}$$

where

$$A = \frac{K}{(1+K)} \quad C0R3 = KC0C1RR3 \left(\frac{Wo}{Q}\right)$$

Thus, using Eq. (7), Q is written as Eq. (9).

[Equation 5]

$$Q = \frac{Q^*}{1- KC0C1RR3Wo^{3}} = \frac{Q^*}{1 - \dfrac{KR3}{(1+K)(\frac{1}{gm})(\frac{R1+R2}{R1})}} \qquad (9)$$

Now referring to Fig. 1, a first-order filter is implemented by the transconductance amplifier 1 and capacitor C0; another first-order filter is implemented by the resistor R3 and capacitor C2; and still another first-order filter is implemented by the resistor R and capacitor C1. Thus, the aforedescribed active LPF comprises a third-order filter, which can be seen from the fact that a term S3 is contained in the transfer function represented by Eq. (5). The third-order filter with R3 can have a greater value of Q as compared to a second-order filter with R3 = 0; with the circuit shown in Fig. 1, in the cut-off frequency f0 (angular frequency w0), the third-order component implemented by R3 and K • C0 serves to enhance the value of Q by reducing the imaginary component.

If w = w0 , then s = jw0 ; by substituting it into Eq. (5), the transfer function is expressed in second-order form as Eq. (10).

[Equation 6]

$$\frac{Vout}{Vin} = \frac{(\frac{R1+R2}{R1})^*H^*(Wo)^{2}}{S^{2}+\frac{Wo}{Q}{}^*S+(Wo)^{2}} \qquad (10)$$

The transfer function of the above Eq. (5), although written in a third-order equation, is in unique form; in other words, it can be seen that the active LPF of the present invention is a unique third-order filter. It is because R3 is provided that the active LPF acts as a unique third-order filter. Now, since Eq. (7) holds true, the input/output phase difference is 90 degrees, as may be seen from Eqs. (11), (12) and (13) described later.

Additionally, as can be seen from Eq. (9), by varying R3, the input/output phase q (phase) assumes either 0, -90, or +90 degrees at w0. This may be expressed as Eqs. (11)-(13). In this way, R3 also serves to adjust the phase as well.

[Equation 7]

$$\text{If } W=Wo \text{ and } R3 < \frac{(1+K)^*(\frac{1}{gm})^*(\frac{R1+R2}{R1})}{K} \text{ , then q (phase) = -90 degrees} \qquad (11)$$

$$\text{If } W=Wo \text{ and } R3 = \frac{(1+K)^*(\frac{1}{gm})^*(\frac{R1+R2}{R1})}{K} \text{ , then q (phase) = 0 degrees} \qquad (12)$$

$$\text{If } W=Wo \text{ and } R3 > \frac{(1+K)^*(\frac{1}{gm})^*(\frac{R1+R2}{R1})}{K} \text{ , then q (phase) = +90 degrees} \qquad (13)$$

Thus, according to the present invention, the value of Q can be set greater than 10, for example, as can be seen from the results of experiment described later, so that the passband of the LPF can be narrowed. As compared to the circuit shown in Fig. 10 as the prior art example, the total number of circuit elements is reduced; especially because only one amplifier is used, less noise is introduced. Thus, all things considered, low noise and high C/N can be secured as compared to the prior art active phase shifter circuit, while the S/N ratio can be substantially improved by employing the LPF of the present invention in the FM demodulation system.

The Q value and f0 may be adjusted with the DC gain of the transconductance amplifier 1, capacitance ratio of the capacitors and resistors, although it is more advantageous to adjust the Q value and f0 with the resistors R1, R2 and said DC gain, while reducing the capacitors. This is because the capacitive elements typically occupy a large area when incorporated into integrated circuitry. Thus, it is beneficial to use the resistors R1, R2 in the present invention. Absent the resistors R1 and R2, the value of (R1 + R2)/R1 would be equal to 1, which would cause the adjustment of f0 and Q to become dependent upon C0 and C1, and large C0 and C1 would be required, and, additionally, because the output of the LPF would be directly fed back to the input of the transconductance amplifier 1, the output would be distorted if the dynamic range of the transconductance amplifier is narrow. It should be appreciated that although a technique for increasing R is available, it is not desirable to increase R because thermal noise is also increased.

Additionally, because the DC gain of the amplifier 1 can be varied with the resistors R1 and R2, the output level of the LPF can also be adjusted. Furthermore, because a feedback is implemented from the output terminal of the LPF to the two-stage input terminal by use of C2, the value Q can be enhanced by the capacitance radio of (1 + K).

The active LPF of the present invention also offers the following advantage, in addition to the afore-described benefits. That is, by employing a phase error correction loop for the FM demodulation system, the need for adjusting the Q value and f0 can be completely eliminated. Furthermore, because a phase shifter circuit (coil and discriminator) that is essential to FM demodulation is incorporated into the IC, reductions in application cost, as well as size and weight, can be achieved, and unnecessary emission induced by any phase coil can be eliminated, thereby reducing the influence on other RF circuits.

With the afore-described active LPF, the temperature dependency of w0 and Q value can be theoretically reduced to zero by adjusting the temperature coefficient of gm of the amplifier 1. That is, w0 and Q value can be expressed as Eqs. (14) and (15), respectively, because the temperature characteristics Tc (C0) and Tc (C1) of C0 and C1, respectively, are both approximate to zero.

[Equation 8]

$$Wo = \cfrac{1}{\sqrt{(1+K)C0C1R(\frac{1}{gm})(\frac{R1+R2}{R1})}} \tag{14}$$

$$= \cfrac{1}{\sqrt{(1+K)C0C1(\frac{R1+R2}{R1})}} * \sqrt{\frac{gm}{R}}$$

(which is proportional to

$$\sqrt{\frac{gm}{R}},$$

and Tc(C0) = Tc(C1) = 0 )

$$Q = \cfrac{\sqrt{\cfrac{(1+K)C1R}{C0(\frac{1}{gm})(\frac{R1+R2}{R1})}}}{1-\cfrac{KR3}{(1+K)*(\frac{1}{gm})*(\frac{R1+R2}{R1})}} \tag{15}$$

$$= \cfrac{\sqrt{\cfrac{(1+K)C1}{C0(\frac{R1+R2}{R1})}} * \sqrt{Rgm}}{1-\cfrac{K}{(1+K)*(\frac{R1+R2}{R1})}*(R3gm)}$$

which is proportional to $\cfrac{\sqrt{Rgm}}{1-\cfrac{K}{(1+K)*(\frac{R1+R2}{R1})}*(R3gm)}$

6

because Tc(C0) = Tc(C1) = 0

Differentiating w0 and Q with temperature T yields Eqs. (16) and (17).

[Equation 9]

$$\frac{\partial Wo}{\partial T} = \frac{\partial Wo}{\partial gm} * \frac{\partial gm}{\partial T} + \frac{\partial Wo}{\partial R} * \frac{\partial R}{\partial T} \quad (16)$$

$$= \frac{1}{2}\sqrt{\frac{1}{gmR}}\frac{\partial gm}{\partial T} - \frac{1}{2}\sqrt{\frac{gm}{R3}}\frac{\partial R}{\partial T}$$

$$= \frac{1}{2}\sqrt{\frac{gm}{R}}(\frac{1}{gm}*\frac{\partial gm}{\partial T}) - \frac{1}{2}\sqrt{\frac{gm}{R}}(\frac{1}{R}*\frac{\partial R}{\partial T})$$

$$= \frac{1}{2}\sqrt{\frac{gm}{R}}(\frac{1}{gm}*\frac{\partial gm}{\partial T} - \frac{1}{R}*\frac{\partial R}{\partial T})$$

$$\frac{\partial Q}{\partial T} = \frac{\partial Q}{\partial gm} * \frac{\partial gm}{\partial T} + \frac{\partial Q}{\partial R} * \frac{\partial R}{\partial T} \mid Tc(R) = Tc(R3), R3=A*R \quad (17)$$

$$= \frac{\frac{1}{2}\sqrt{\frac{R}{gm}}\{1-\frac{K(A*R*gm)}{(1+K)(\frac{R1+R2}{R1})}\} - \sqrt{Rgm}\{\frac{K(A*R)}{(1+K)(\frac{R1+R2}{R1})}\}}{\{1-\frac{K(A*R*gm)}{(1+K)(\frac{R1+R2}{R1})}\}^2} * \frac{\partial gm}{\partial T}$$

$$+ \frac{\frac{1}{2}\sqrt{\frac{gm}{R}}\{1-\frac{K(A*R*gm)}{(1+K)(\frac{R1+R2}{R1})}\} - \sqrt{Rgm}\{\frac{K*A*gm}{(1+K)(\frac{R1+R2}{R1})}\}}{\{1-\frac{K(A*R*gm)}{(1+K)(\frac{R1+R2}{R1})}\}^2} * \frac{\partial R}{\partial T}$$

$$= \frac{\frac{1}{2}\sqrt{Rgm}\{1-\frac{K(A*R*gm)}{(1+K)(\frac{R1+R2}{R1})}\} - \sqrt{Rgm}\{\frac{K(A*R*gm)}{(1+K)(\frac{R1+R2}{R1})}\}}{\{1-\frac{K(A*R*gm)}{(1+K)(\frac{R1+R2}{R1})}\}^2}$$

$$* (\frac{1}{gm} * \frac{\partial gm}{\partial T} + \frac{1}{R} * \frac{\partial R}{\partial T})$$

Thus, given Eq. (16), if the temperature coefficients for gm and R are made equal to each other, then [Tc (gm) = Tc (R)] and temperature variations for w0 are theoretically reduced to zero. In addition, if the absolute values of the temperature coefficients for gm and R are made equal to each other in Eq. (17), and thus assuming that Tc (gm) = -Tc (R) , then temperature variability for Q value are theoretically reduced to zero.

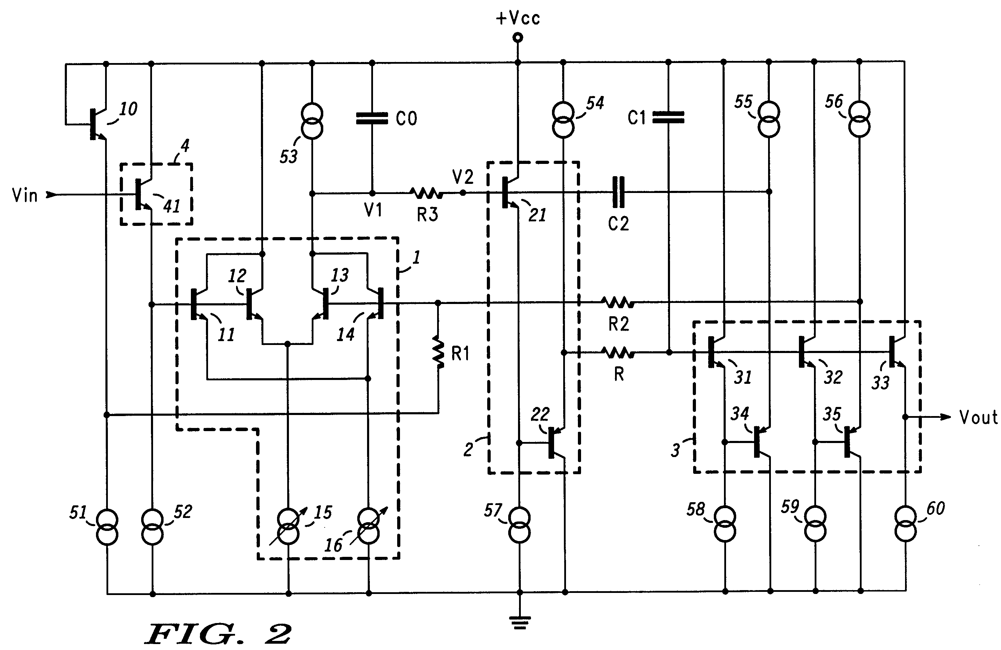

Next, an embodiment of the active LPF according to the present invention is illustrated in Fig. 2.

In this embodiment, an input signal Vin is applied to a transconductance amplifier 1 through an emitter follower 4 that is comprised of a transistor 41. The transconductance amplifier 1 includes differentially connected transistors (11, 14) and (12, 13), and current controllers 15 and 16. The voltage V1 at the output of the transconductance amplifier is converted via resistor R3 to a voltage V2, which is then outputted to an emitter of a transistor 22 of a first emitter follower 2 which is comprised of transistors 21 and 22 connected in two stages. A second emitter follower 3 is configured so that bases of transistors 31, 32, and 33 are connected to the output of the resistor R, while bases of transistors 34 and 35 are connected to emitters of the transistors 31 and 32, respectively, thereby separating the feedback output terminal from the output terminal of the LPF where the output signal Vout is extracted. The output terminals are separated in that manner in order to avoid the influence of the capacitor C2 on the next-stage circuit of the LPF. Note that reference numerals 51-60 in Fig. 2 denote constant current sources. In the above example, capacitors C0 and C1 are connected to VCC, while the resistor R1 is AC grounded; however, the capacitors C0 and C1 may be AC grounded (first potential source), while the resistor R1 may be connected to VCC (second potential source) according to the present invention.

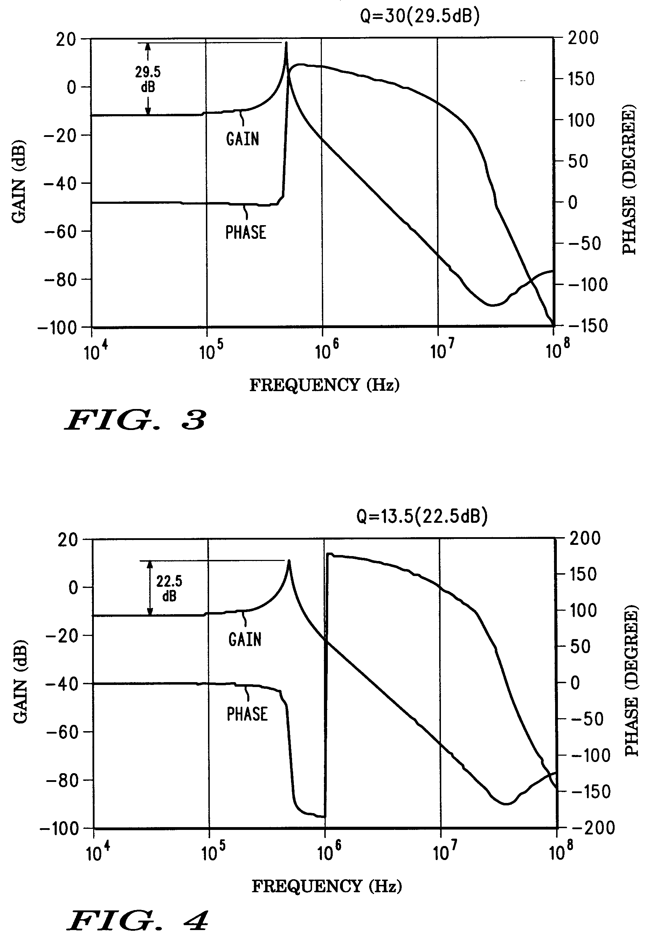

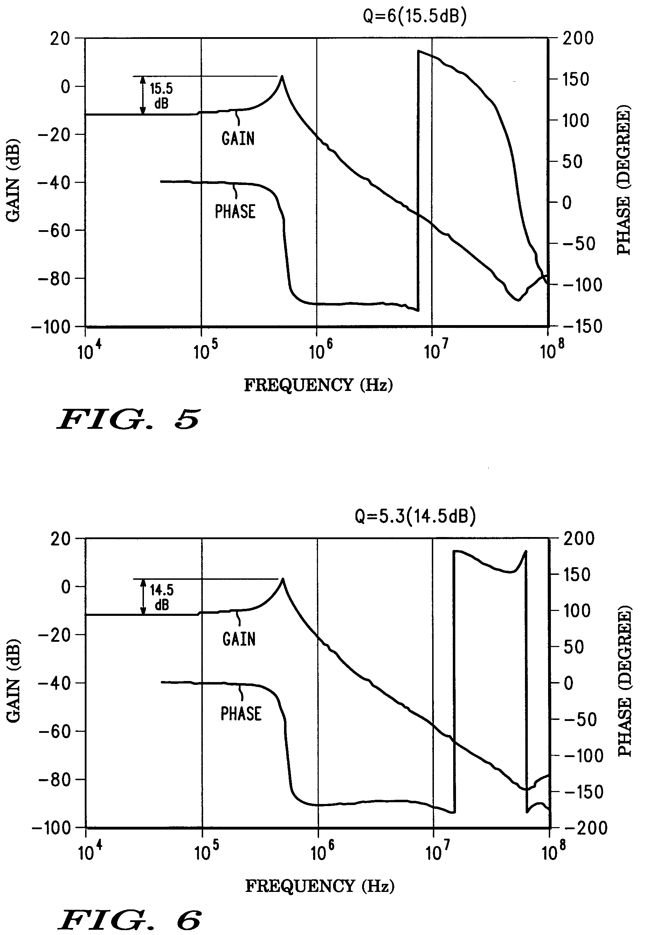

A simulation circuit was created in accordance with the circuit of Fig. 1, and computer simulation was performed to determine how the gain of the LPF and input/output phase deviation would vary as the value of the resistor R3 was changed. Figs. 3-6 show graphs indicating the results, where R3 is either 5 k$\Omega$, 2.5 k$\Omega$, 0.5 k$\Omega$, and 0 $\Omega$. Note that C0 and C1 are 15 PF and 40 PF, respectively; K is 5; R1, R2, and R are 1.5 k$\Omega$, 2 k$\Omega$, and 12 k$\Omega$, respectively. As can be seen from the results, the value of Q changes as R3 is varied, and the value of Q can be as high as 30, for example, as shown in Fig. 3

Accordingly, it should be appreciated that an active LPF of the present invention is not limited to use in an FM demodulation circuit, but may be used in place of an external coil.

Thus, an active LPF according to the present invention offers advantages that it is small and lightweight, and the output noise can be reduced, while attaining a high Q value.

**Claims**

1. An active low-pass filter comprising:

   an amplifier for acquiring a frequency signal into one input terminal and amplifying a differential voltage between one and other input terminals to output it as a current;
   a first capacitive element provided between the output terminal of the amplifier and a first potential source;
   a first impedance converter having its input terminal connected via a first resistor to the output terminal of said amplifier;
   a second impedance converter having its input terminal connected via a second resistor to the output terminal of said first impedance converter and having its output terminal connected to the other input terminal of said amplifier;
   a second capacitive element connected between said second resistor and the input terminal of said second impedance converter and the first potential source; and
   a third capacitive element having one terminal connected between said first resistor and the input terminal of said first impedance converter, and having the other terminal connected to the output terminal of said second impedance converter.

2. The active low-pass filter of claim 1, the filter further comprising:

   a third resistor connected between the other input terminal of said amplifier and a second potential source; and
   a fourth resistor having one terminal connected between the other input terminal of said amplifier and said third resistor, and having the other terminal connected to the output terminal of said second impedance converter.

*FIG. 1*

*FIG. 7*

*FIG. 8*

**FIG. 2**

FIG. 3

FIG. 4

Q=6(15.5dB)

FIG. 5

Q=5.3(14.5dB)

FIG. 6

FIG. 9

FIG. 10

European Patent
Office

**EUROPEAN SEARCH REPORT**

Application Number

EP 96 11 1171

## DOCUMENTS CONSIDERED TO BE RELEVANT

| Category | Citation of document with indication, where appropriate, of relevant passages | Relevant to claim | CLASSIFICATION OF THE APPLICATION (Int.Cl.6) |
|---|---|---|---|
| A | EP-A-0 442 492 (TOKYO SHIBAURA ELECTRIC CO) 21 August 1991 <br> * page 4, line 14 - page 4, line 21; figure 1 * <br> --- | 1 | H03H11/04 |
| A | US-A-5 325 070 (MCGINN MICHAEL) 28 June 1994 <br> * column 1 - column 2, line 29; figure 1 * <br> ----- | 1 | |
| | | | **TECHNICAL FIELDS SEARCHED (Int.Cl.6)** |
| | | | H03H |

The present search report has been drawn up for all claims

| Place of search | Date of completion of the search | Examiner |
|---|---|---|
| THE HAGUE | 15 October 1996 | Coppieters, C |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

 

& : member of the same patent family, corresponding document